# EUROPEAN PATENT APPLICATION

(11) **EP 1 345 259 A2**
(43) Date of publication of application: **17.09.2003**
(21) Application number: 03251457.2
(22) Date of filing: 11.03.2003
(51) Int. Cl.: H01L 21/02, G11C 11/00, H01L 21/28

(54) **Polycrystalline memory structure, method for forming same structure, and semiconductor memory device using same structure**

(30) Priority: 13.03.2002 US 99186
(71) Applicant: Sharp Kabushiki Kaisha, Osaka-shi, Osaka 545-8522 (JP)
(72) Inventor: Hsu, Sheng Teng, Camas, WA 98607 (US); Li, Tingkai, Vancouver,WA98683 (US); Zhuang, Wei-Wei, Vancouver, Wa 98683 (US)
(74) Representative: West, Alan Harry

(57) **Abstract**

The invention provides a polycrystalline memory structure comprising: a polycrystalline memory layer (18) overlying a substrate (14) and having crystal grain boundaries forming gaps (20) between adjacent crystallites; and an insulating material (24) at least partially within the gaps.

## Description

The present invention relates to a polycrystalline memory structure comprising a polycrystalline memory material, such as a perovskite, or ferroelectric, thin film, a method for forming the same structure, and a semiconductor memory device, such as a nonvolatile memory element with resistance variation, using the same structure.

Conventionally, polycrystalline thin films have been used in several known semiconductor memory devices, such as ferroelectric memory devices and other perovskite memory devices. As the semiconductor memory devices, Metal/Ferroelectric/Metal (MFM) capacitors, gate stacks of Metal/Ferroelectric/Insulator/Semiconductor (MFIS) for single transistor memory and Metal/Ferro-electric/Metal/Insulator/Semiconductor (MFMIS) gate stack memory transistors have been researched and developed. A two terminal memory can also be fabricated with polycrystalline memory materials, such as, colossal magneto-resistive (CMR) materials, and high temperature super-conducting (HTSC) materials. Some of these memory structures have been demonstrated and studied extensively over the past ten years producing a memory cell with many outstanding characteristics.

However, the conventional polycrystalline memory material used for memory cells has grain boundaries between adjacent crystallites. These grain boundaries form at least one gap between crystallites. The polycrystalline memory material also has a rough upper surface. When a top metal electrode is deposited overlying the polycrystalline memory material, the metal may deposit into the gaps between crystallites. Metal in the gaps causes the distance between the top electrode and any bottom electrode to be smaller than the distance between metal at the top of the crystallite and the bottom electrode. The deposited metal may continue to diffuse further into the gap along the grain boundaries during subsequent processing. The metal in the gap between crystallites may produce a short between the top electrode and the bottom electrode. Even if a short is not formed, the electric field intensity due to metal in the gap is substantially larger than that at the top surface of the crystallite. The increased electric field intensity is one possible source of increased leakage current and low breakdown voltage. In some cases, the leakage current may be sufficiently large to severely affect the charge retention of the semiconductor memory device. The presence of metal in the gap between crystallites presents a severe fabrication yield and device reliability problem for individual memory cells. The failure of only a few cells causes the loss of an entire memory array.

As described above, there is a possibility that memory cells having a large a leakage current might be present in the entire memory array. Even the presence of a few leaky memory cells can so significantly reduce functionality and yield as to impair the technical and economic viability of these memory materials in large memory arrays and therefore large arrays of these memory structures have not been successfully fabricated.

According to one aspect of the present invention, there is provided a polycrystalline memory structure comprising: a polycrystalline memory layer provided overlying a substrate, the polycrystalline memory layer having crystal grain boundaries forming gaps between adjacent crystallites; and a first insulating material located at least partially within the gaps.

In one embodiment of the invention, the polycrystalline memory layer is at least one of materials selected from the group consisting of a perovskite material, a ferroelectric material, a colossal magneto-resistive (CMR) material, and a high temperature super-conducting (HTSC) material.

In another embodiment of the invention, the polycrystalline memory layer is at least one of materials selected from the group consisting of PZT, PLZT, PLT, SBT, SBTN, BST, BSTO, PGO, and PSGO.

In still another embodiment of the invention, the first insulating material is at least one of materials selected from the group consisting of silicon dioxide, silicon nitride, hafnium oxide, zirconium oxide, aluminum oxide, aluminum nitride, tantalum oxide, aluminum-doped hafnium oxide, and aluminum-doped zirconium oxide.

In still another embodiment of the invention, the polycrystalline memory structure further comprises a bottom electrode interposed between the polycrystalline memory layer and the substrate.

In still another embodiment of the invention, the bottom electrode is at least one of materials selected from the group consisting of iridium, platinum, ruthenium oxide, and iridium tantalum oxide.

In still another embodiment of the invention, the polycrystalline memory structure further comprises a second insulating material interposed between the bottom electrode and the substrate.

In still another embodiment of the invention, the second insulating material is at least one of materials selected from the group consisting of silicon dioxide, silicon nitride, hafnium oxide, zirconium oxide, aluminum oxide, aluminum nitride, tantalum oxide, aluminum-doped hafnium oxide, and aluminum-doped zirconium oxide.

In still another embodiment of the invention, the polycrystalline memory structure further comprises at least one of a hafnium oxide layer and a zirconium oxide layer interposed between the polycrystalline memory layer and the substrate.

In still another embodiment of the invention, the polycrystalline memory structure further comprises a top electrode overlying the polycrystalline memory layer.

In still another embodiment of the invention, the top electrode is at least one of materials selected from the group consisting of platinum, iridium, iridium oxide, ruthenium oxide, and iridium tantalum oxide.

According to another aspect of the present invention, there is provided a method for forming a polycrystalline memory structure comprising the steps of: providing a memory material overlying a substrate; annealing the memory material to produce a polycrystalline memory material having gaps formed at various grain boundaries; and providing an insulating material over the polycrystalline memory material, whereby the insulating material at least partially fills the gaps.

In one embodiment of the invention, the polycrystalline memory material is a perovskite material, a ferroelectric material, a colossal magneto-resistive (CMR) material, or a high temperature super-conducting (HTSC) material.

In another embodiment of the invention, the polycrystalline memory material is PZT, PLZT, PLT, SBT, SBTN, BST, BSTO, PGO, or PSGO.

In still another embodiment of the invention, the insulating material is silicon dioxide, silicon nitride, hafnium oxide, zirconium oxide, aluminum oxide, aluminum nitride, tantalum oxide, aluminum-doped hafnium oxide, or aluminum-doped zirconium oxide.

In still another embodiment o f the invention, the insulating material is deposited using a chemical vapor deposition (CVD) process or a sputtering process.

In still another embodiment of the invention, the method for forming a polycrystalline memory structure further comprises the step of planarizing the insulating material to partially expose the polycrystalline memory material.

In still another embodiment of the invention, the step of planarizing the insulating material is accomplished using a CMP process.

In still another embodiment of the invention, the method for forming a polycrystalline memory structure further comprises planarizing the polycrystalline memory material prior to depositing the insulating material.

In still another embodiment of the invention, the method for forming a polycrystalline memory structure further comprises the step of forming a bottom electrode overlying the substrate prior to depositing the polycrystalline memory material.

In still another embodiment of the invention, the bottom electrode is at least one of materials selected from the group consisting of platinum, iridium, iridium oxide, ruthenium oxide, and iridium tantalum oxide.

In still another embodiment of the invention, the method for forming a polycrystalline memory structure further comprises the step of forming an insulator overlying the substrate prior to forming the bottom electrode.

In still another embodiment of the invention, the insulator is silicon dioxide, silicon nitride, hafnium oxide, zirconium oxide, aluminum oxide, aluminum nitride, tantalum oxide, aluminum-doped hafnium oxide, or aluminum-doped zirconium oxide.

In still another embodiment of the invention, the method for forming a polycrystalline memory structure further comprises the step of forming an insulator overlying the substrate prior to depositing the polycrystalline memory material.

In still another embodiment of the invention, the insulator is hafnium oxide or zirconium oxide.

In still another embodiment of the invention, the method for forming a polycrystalline memory structure further comprises the step of forming a top electrode over the polycrystalline memory material.

In still another embodiment of the invention, the top electrode is platinum, iridium, iridium oxide, ruthenium oxide, or iridium tantalum oxide.

According to still another aspect of the present invention, there is provided a semiconductor memory device using a polycrystalline memory structure of the first aspect of the present invention.

Hereinbelow, functions of the above configuration will be described.

According to the present invention, in a polycrystalline memory structure comprising a polycrystalline memory layer, which has crystal grain boundaries forming gaps between adjacent crystallites overlying a substrate, an insulating material is located at least partially within the gaps to at least partially block the entrance to the gaps , so the amount of subsequently deposited metal entering the gaps is reduced, or eliminated.

Further, according to a method of forming a polycrystalline memory structure of the present invention, polycrystalline memory material is deposited on a substrate and the deposited material is annealed to form a polycrystalline memory layer having gaps between adjacent crystallites on the substrate. An insulating layer is deposited over the polycrystalline memory layer to at least partially fill the gaps, thereby blocking a portion of each gap.

Thus, leakage current caused by the presence of gaps in a thin film of a polycrystalline memory layer used for a memory cell is reduced, thereby improving reliability and yield of devices.

Note that this leakage is due in part to the polycrystalline form of the polycrystalline memory materials used. In order for ferroelectric materials to have good ferroelectric properties, the polycrystalline memory materials are preferably in crystalline form, including polycrystalline form.

Thus, the invention described herein makes possible the advantages of providing: (1) a polycrystalline memory structure capable of reducing leakage current of polycrystalline memory thin films used for memory cells, thereby improving reliability and yield of devices; (2) a method for forming the same structure; and (3) a semiconductor device using the same structure.

This and other advantages of the present invention will become apparent to those skilled in the art upon reading and understanding the following detailed description with reference to the accompanying figures.

Fig. 1 is a cross-sectional view of a device structure 11A during processing according to an embodiment of a method for forming a polycrystalline memory structure of the present invention.

Fig. 2 is a cross-sectional view of a device structure 11B during processing according to an embodiment of the method for forming a polycrystalline memory structure of the present invention.

Fig. 3 is a cross-sectional view of a device structure 11C during processing according to an embodiment of the method for forming a polycrystalline memory structure of the present invention.

Fig. 4 is a cross-sectional view of a device structure 11D during processing according to an embodiment of the method for forming a polycrystalline memory structure of the present invention.

Fig. 5 is a cross-sectional view of a device structure 11E after the completion of processing according to an embodiment of the method for forming a polycrystalline memory structure of the present invention.

Fig. 6 is a cross-sectional view of a device structure 11F during processing according to another embodiment of the method for forming a polycrystalline memory structure of the present invention.

Fig. 7 is a cross-sectional view of a device structure 11G during processing according to another embodiment of the method for forming a polycrystalline memory structure of the present invention.

Fig. 8 is a cross-sectional view of a device structure 11H during processing according to another embodiment of the method for forming a polycrystalline memory structure of the present invention.

Fig. 9 is a cross-sectional view of a device structure 11I during processing according to another embodiment of the method for forming a polycrystalline memory structure of the present invention.

Fig. 10 is a cross sectional view of a device structure 11 J after the completion of processing according to another embodiment of the method for forming a polycrystalline memory structure of the present invention.

Hereinafter, embodiments of the present invention will be described with respect to a polycrystalline memory structure and a method for forming the same structure and with reference to the accompanying drawings.

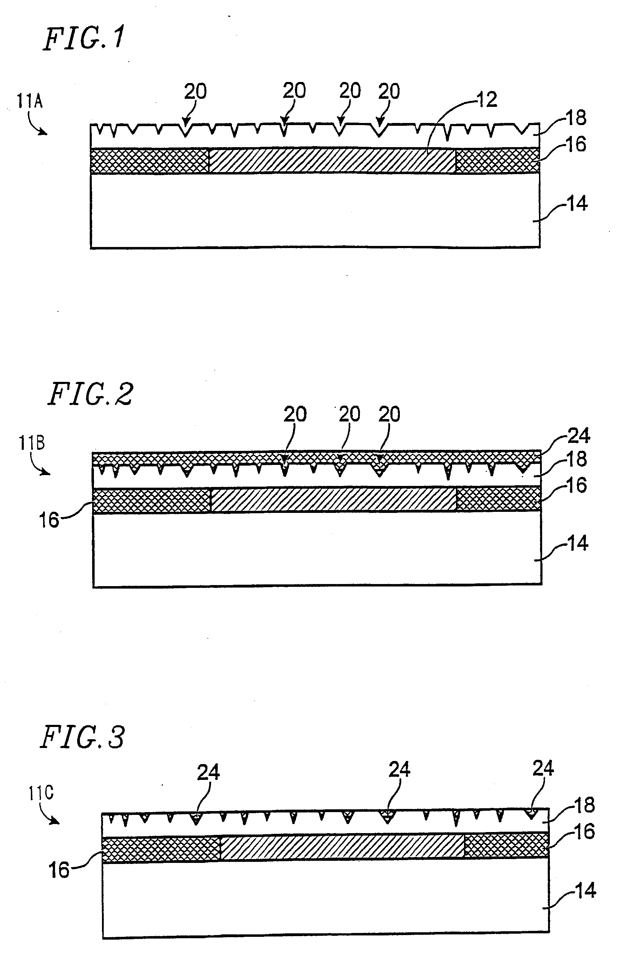

Fig. 1 is a cross-sectional view of a device structure 11A during processing according to an embodiment of a method for forming a polycrystalline memory structure of the present invention.

Note that polycrystalline memory material used for a semiconductor memory device, e.g., a non-volatile memory element with resistance variation or the like, of the present invention refers to a material that is polycrystalline after deposition, or deposition and annealing, which is suitable for non-volatile memory applications.

The present invention overcomes the problem of gaps between crystallites and the effect of metal filling those gaps. The present invention employs a variety of materials , including perovskite materials, ferroelectric materials, colossal magneto-resistive (CMR) materials, and high temperature super-conducting (HTSC) materials, as polycrystalline memory materials.

As shown in Fig. 1, a bottom electrode 12 has been formed overlying a substrate 14. The substrate 14 is a silicon substrate, or other suitable substrate material, including other semiconductor materials or semiconductor on insulator substrates. In one embodiment, a layer of oxide 16 is deposited overlying the substrate 14 and etching in a trench on portions of the oxide layer 16 where the bottom electrode 12 is to be formed. Metal is deposited overlying the oxide layer 16 and the substrate 14 in the trench to fill the trench.

The top surface of the metal is then planarized, for example using a CMP process , to form the bottom electrode 12. The bottom electrode 12 is preferably a noble metal or a conductive noble metal oxide, for example platinum, iridium, iridium oxide, ruthenium oxide, or iridium tantalum oxide.

After forming the bottom electrode 12, a material for a polycrystalline memory layer 18 is deposited overlying the bottom electrode 12 and the oxide layer 16, and the deposited material is annealed. The polycrystalline memory layer 18 has grain boundaries which form gaps 20 in the surface of the polycrystalline memory layer 18. The gaps 20 may vary in size and depth, and some of the gaps 20 may extend completely through the polycrystalline memory layer 18 to the bottom electrode 12. The polycrystalline memory material is a perovskite material, a ferroelectric material, a CMR material, or a HTSC material. The polycrystalline memory material may be selected from PbZrₓTi₁₋ₓO₃ (PZT), (Pb, La) (ZrTi)O₃ (PLZT), (PbLa)TiO₃ (PLT), SrBi₂Ta₂O₉ (SBT), SrBi₂(Ta₁₋ₓNbₓ)₂O₉ (SBTN), (Ba,Sr)TiO₃ (referred to as BST or BSTO), Pb₅Ge₃O₁₁ (PGO), (Pb₁₋ₓSnₓ)₅Ge₃O₁₁ (PSGO), or other perovskite material, ferroelectric material, or suitable polycrystalline memory material.

Fig. 2 is a cross-sectional view of a device structure 11B during processing according to an embodiment of the method for forming a polycrystalline memory structure of the present invention.

As shown in Fig. 2, an insulating layer 24 is deposited overlying the polycrystalline memory layer 18. The insulating layer 24 at least partially fills the gaps 20 in the surface of the polycrystalline memory layer 18 to plug the gaps 20 and reduce, or eliminate, the amount of subsequently deposited metal entering the gaps 20.

Although, the insulating layer 24, may in some cases of the present invention completely fill one or more gaps 20, it is not necessary for the insulating layer 24 to completely fill the gaps 20. The insulating layer 24 will either partially block the opening of the gaps 20, or completely block the opening of the gaps 20, to reduce or eliminate, the amount of subsequently deposited metal entering the gaps 20. This insulating layer 24 may comprise silicon oxide, silicon nitride, or high-k insulating materials (high dielectric constant materials) such as hafnium oxide, zirconium oxide, aluminum oxide, aluminum nitride, tantalum oxide, aluminum-doped hafnium oxide, aluminum-doped zirconium oxide. The insulating layer 24 is deposited using chemical vapor deposition (CVD), sputtering, or other suitable method for depositing the desired material. As used here, CVD refers to any method of CVD, for example, plasma-enhanced CVD, atomic layer CVD, metal oxide CVD, or other CVD processes.

Fig. 3 is a cross-sectional view of a device structure 11C during processing according to an embodiment of the method for forming a polycrystalline memory structure of the present invention.

As shown in Fig. 3, the insulating layer 24 is planarized from the top surface thereof, for example using a CUP process. By planarizing the insulating layer 24, the polycrystalline memory layer 18 may be exposed. That is, during the planarization of the insulating layer 24, a portion of the polycrystalline memory layer 18 may also be planarized.

In another embodiment, a portion of the insulating layer 24 may remain over the polycrystalline memory layer 18. Although, this may reduce the memory window and require the drain to be operated at higher voltages, the memory device is still operational without degrading reliability.

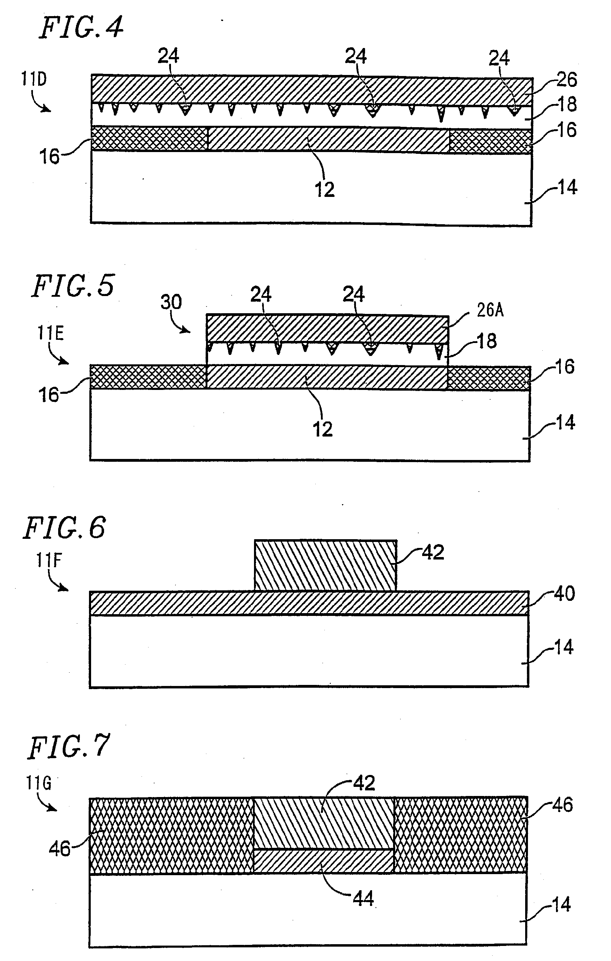

Fig. 4 is a cross-sectional view of a device structure 11D during processing according to an embodiment of the method for forming a polycrystalline memory structure of the present invention.

As shown in Fig. 4, a top electrode layer 26 is deposited over the insulating layer 24 and the polycrystalline memory layer 18. The top electrode layer 26 may be a noble metal, or a conductive noble metal oxide, such as, platinum, iridium, iridium oxide, ruthenium oxide, or iridium tantalum oxide.

Fig. 5 is a cross-sectional view of a device structure 11E after the completion of processing according to an embodiment of the method for forming a polycrystalline memory structure of the present invention.

As shown in Fig. 5, a top electrode 26A is formed by etching and patterning the top electrode layer 26 so as to have a prescribed shape. At this time, the polycrystalline memory layer 18 is also patterned to complete the polycrystalline memory gate stack 30, which comprises, a remaining portion of the polycrystalline memory layer 18, a remaining portion of the insulating layer 24, and the top electrode 26A.

Additional known processes may then be performed on the resulting device structure 11E to form a polycrystalline memory structure. An alternative embodiment or the device structure 11E, utilizing a trench structure, is shown in Figs. 6-10.

Fig. 6 is a cross-sectional view of a device structure 11F during processing according to another embodiment of the method for forming a polycrystalline memory structure of the present invention.

As shown in Fig. 6, a bottom electrode layer 40 is deposited overlying the substrate 14 . A silicon nitride layer, or other suitable sacrificial material, is deposited overlying the bottom electrode layer 40. The deposited layer is patterned to have a prescribed shape, thereby forming a sacrificial gate structure 42.

The bottom electrode layer 40 is then etched, possibly using the sacrificial gate structure 42 as a mask. Alternatively, the bottom electrode layer 40 may be etched using the same mask as that used to pattern the sacrificial gate structure.

Fig. 7 is a cross-sectional view of a device structure 11G during processing according to another embodiment of the method for forming a polycrystalline memory structure of the present invention.

As shown in Fig. 7, after etching (patterning) described in conjunction with Fig. 6, a portion of the patterned bottom electrode layer 40 remains as a bottom electrode 44.

A layer of oxide 46, or other suitable insulating material, is then deposited overlying the substrate and the sacrificial gate structure. The oxide layer 46 is then planarized from the top surface thereof, for example using a CMP process.

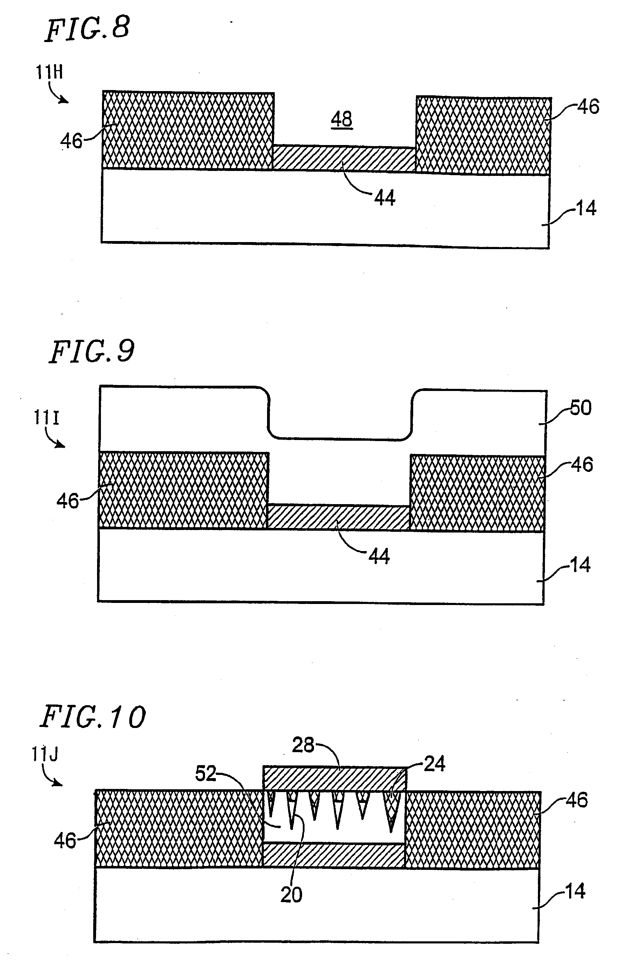

Fig. 8 is a cross-sectional view of a device structure 11H during processing according to another embodiment of the method for forming a polycrystalline memory structure of the present invention.

As shown in Fig. 8, the sacrificial gate structure 42 is then removed leaving a trench 48. For example, if the sacrificial gate structure 42 is composed of silicon nitride, a hot phosphoric acid etch may be used to remove the sacrificial gate structure 42.

Fig. 9 is a cross-sectional view of a device structure 111 during processing according to another embodiment of the method for forming a polycrystalline memory structure of the present invention.

As shown in Fig. 9, the polycrystalline memory layer 50 is then deposited overlying the oxide layer 46 and the bottom electrode 44 in the trench 48.

Fig. 10 is a cross sectional view of a device structure 11 J after the completion of processing according to another embodiment of the method for forming a polycrystalline memory structure of the present invention.

As shown in Fig 10, the polycrystalline memory layer 50 is then planarized from the top surface thereof to form a polycrystalline memory gate structure 52, for example using a CMP process. The polycrystalline memory gate structure 52 has gaps 20 formed at the boundaries of adjacent crystallites.

The insulating layer 24 is then deposited over the polycrystalline memory layer 50, to block, or fill, the gaps 20.

As described above, according to each of the above-described embodiments, in a polycrystalline memory structure for a semiconductor memory device employing polycrystalline memory materials comprising a polycrystalline memory layer 18 or 50, which has crystal grain boundaries forming gaps 20 between adjacent crystallites overlying a substrate 14, an insulating layer 24 is located at least partially within the gaps 20 to at least partiallyblock the entrance to the gaps 20 , thereby improving low breakdown voltage caused by the gaps 20 formed in a thin film of a polycrystalline memory used for a memory cell and reducing leakage current due to the low breakdown voltage. Thus, reliability and yield of devices can be improved.

Note that in one embodiment, the insulator layer 24 is planarized and the top electrode 28 is formed by depositing a top metal layer overlying the insulator layer 24 and patterning the top metal layer so as to have a prescribed shape.

The above illustrated embodiments illustrate a simple MFM capacitor. The present invention also applies to MFIS devices where an additional layer of insulating material, for example hafnium oxide or zirconium oxide, is deposited over the substrate instead of the bottom electrode and patterned.

In another embodiment, the additional layer of insulating material is deposited over the substrate prior to forming the bottom electrode, such that the additional layer of insulating material is interposed between the substrate and the bottom electrode. This forms a MFMIS structure. The additional layer of insulating material may be silicon dioxide, silicon nitride, or a high-k insulator material such as, hafnium oxide, zirconium oxide, aluminum oxide, aluminum nitride, tantalum oxide, aluminum-doped hafnium oxide, or aluminum-doped zirconium oxide.

As described above, according to the present invention, an insulating layer is located at least partially within gaps to at least partially block the entrance to the gaps, thereby improving low breakdown voltage caused by the gaps formed in a polycrystalline memory thin film used for a memory cell and reducing leakage current flowing through the gaps. Thus, reliability and yield of devices can be improved.

## Claims

1. A polycrystalline memory structure comprising:
a polycrystalline memory layer (18,50) overlying a substrate (14) and having crystal grain boundaries forming gaps (20) between adjacent crystallites; and
a first insulating material (24) located at least partially within the gaps.

2. A structure according to claim 1, wherein the polycrystalline memory layer is at least one selected from perovskite, ferroelectric, colossal magneto-resistive (CMR) and high temperature super-conducting (HTSC) materials.

3. A structure according to claim 1 or claim 2, wherein the polycrystalline memory layer is at least one selected from PZT, PLZT, PLT. SET, SBTN, BST, BSTO, PGO and PSGO.

4. A structure according to any one of claims 1 to 3, wherein the first insulating material is at least one selected from silicon dioxide, silicon nitride. hafnium oxide, zirconium oxide, aluminum oxide, aluminum nitride, tantalum oxide, aluminum-doped hafnium oxide and aluminum-doped zirconium oxide.

5. A structure according to any one of claims 1 to 4, further comprising a bottom electrode (12,44) interposed between the polycrystalline memory layer (18,50) and the substrate (14).

6. A structure according to claim 5, wherein the bottom electrode is at least one selected from iridium, platinum, ruthenium oxide and iridium tantalum oxide.

7. A structure according to claim 5 or claim 6, further comprising a second insulating material interposed between the bottom electrode and the substrate.

8. A structure according to claim 7, wherein the second insulating material is at least one selected from silicon dioxide, silicon nitride, hafnium oxide, zirconium oxide, aluminum oxide, aluminum nitride, tantalum oxide, aluminum-doped hafnium oxide and aluminum-doped zirconium oxide.

9. A structure according to any one of claims 1 to 8, further comprising at least one of a hafnium oxide layer and a zirconium oxide layer interposed between the polycrystalline memory layer and the substrate.

10. A structure according to any one of claims 1 to 9, further comprising a top electrode (26,28) overlying the polycrystalline memory layer.

11. A structure according to claim 10, wherein the top electrode is at least one selected from platinum, iridium, iridium oxide, ruthenium oxide and iridium tantalum oxide.

12. A method for forming a polycrystalline memory structure comprising the steps of:
forming a memory material (18,50) overlying a substrate (14);
annealing the memory material to produce a polycrystalline memory material having gaps (20) formed at various grain boundaries; and
forming an insulating material (24) over the polycrystalline memory material, whereby the insulating material at least partially fills the gaps.

13. A method according to claim 12, wherein the insulating material is formed by chemical vapor deposition (CVD) or by sputtering.

14. A method according to claim 12 of claim 13, further comprising the step of planarizing the insulating material thereby partially to expose the polycrystalline memory material.

15. A method according to claim 14, wherein planarizing is accomplished by CMP.

16. A method according to any one of claims 12 to 15, further comprising planarizing the polycrystalline memory material prior to forming the insulating material.

17. A method according to any one of claims 12 to 16, further comprising the step of forming a bottom electrode (12,44) overlying the substrate prior to forming the memory material.

18. A method according to claim 17, further comprising the step of forming an insulator overlying the substrate prior to forming the bottom electrode.

19. A method according to any one of claims 12 to 16, further comprising the step of forming an insulator overlying the substrate prior to forming the memory material.

20. A method according to any one of claims 12 to 19, further comprising the step of forming a top electrode (26,28) over the polycrystalline memory material.

21. A semiconductor memory device comprising a polycrystalline memory structure according to any one of claims 1 to 11.
